# EUROPÄISCHE PATENTSCHRIFT

(11) **EP 2 915 221 B1**
(45) Veröffentlichungstag und Bekanntmachung des Hinweises auf die Patenterteilung: **02.10.2019**
(21) Anmeldenummer: 13734035.2
(22) Anmeldetag: 29.06.2013
(51) Int. Cl.: H01R 13/631, H05K 5/00, H01R 13/623, H01R 12/58

(54) **ELEKTRISCHE STECKERAUFNAHME FÜR EIN FAHRZEUG**
ELECTRICAL PLUG RECEPTACLE FOR A VEHICLE
TÊTE DE PRISE ÉLECTRIQUE POUR VÉHICULE

(30) Priorität: 18.07.2012 DE 102012106474
(43) Veröffentlichungstag der Anmeldung: 09.09.2015
(73) Patentinhaber: HELLA GmbH & Co. KGaA, 59552 Lippstadt (DE)
(72) Erfinder: GOLLNICK, Ansgar, 33106 Paderborn (DE); NEESEN, Christian, 33142 Büren (DE)
(86) Internationale Anmeldenummer: PCT/EP2013/063754
(87) Internationale Veröffentlichungsnummer: WO 2014/012771

(56) Entgegenhaltungen:
- EP-A2- 0 923 172
- WO-A2-2008/088821
- US-A- 5 980 293
- US-B1- 6 683 789

## Beschreibung

Die Erfindung betrifft eine elektrische Steckeraufnahme für ein Fahrzeug mit mindestens einem Kontaktelement, gemäß dem Oberbegriff von Anspruch 1. Weiterhin offenbart die Erfindung einen Stecker gemäß Anspruch 10.

### Stand der Technik

Die Druckschrift WO 2008/088821 A2, die US 6 683 789 B1 und die US 5 980 293 A zeigen eine Steckeraufnahme mit einem Steckergehäuse mit einer Führungskontur für einen Stecker. Die EP 0 923 172 A2 zeigt ebenfalls eine Steckeraufnahme, die mit einem durch ein Buchengehäuse gebildeten Stecker mit Kontaktelementaufnahmen zusammenwirkt.

Aus der Druckschrift DE 44 23 395 C2 ist eine Steckeraufnahme offenbart, die ein Gehäuse mit einer Öffnung aufweist, wobei durch die Öffnung mehrere Kontaktelemente hindurchgeführt sind. Dabei werden die Kontaktelemente am Gehäuse fixiert. Bei einem Zusammenschluss der Steckeraufnahme mit einem dazugehörigen komplementären Stecker müssen dabei die Kontaktelement die Funktion einer Führung des Steckers in die Steckeraufnahme übernehmen. Dabei treten allerdings horizontale und vertikale Kräfte auf die Kontaktelemente der Steckeraufnahme beim Einführen des Steckers in die Steckeraufnahme auf. Deshalb werden die Kontaktelemente an das Gehäuse angeordnet, um die auftretenden Kräfte an das Gehäuse abzuleiten und die Kontaktelemente in ihrer Lage zu fixieren.

### Offenbarung der Erfindung

Es ist Aufgabe der vorliegenden Erfindung, eine elektrische Steckeraufnahme für ein Fahrzeug mit mindestens einem Kontaktelement bereitzustellen, wobei die Steckeraufnahme einfach und zuverlässig aufgebaut ist, um einen sicheren und schnellen Kontakt zwischen der Steckeraufnahme und dem Stecker bereitzustellen. Insbesondere ist es Aufgabe der vorliegenden Erfindung, eine elektrische Steckeraufnahme bereitzustellen, wobei im Falle eines Kontaktes des Steckers mit der elektrischen Steckeraufnahme die Kontaktelemente nur in vertikaler Richtung, d. h. in Richtung der Steckverbindung, kräftemäßig belastet werden.

Zur Lösung dieser Aufgabe wird eine elektrische Steckeraufnahme mit den Merkmalen des Anspruches 1, insbesondere mit den Merkmalen des gekennzeichneten Teils, vorgeschlagen. Weiterhin wird die Aufgabe gelöst durch einen Stecker mit den Merkmalen des Patentanspruches 10. In den abhängigen Ansprüchen sind bevorzugte Weiterbildungen ausgeführt. Dabei können die in den Ansprüchen und in der Beschreibung erwähnten Merkmale jeweils für sich oder in Kombination erfindungswesentlich sein. Merkmale und Details, die im Zusammenhang mit dem erfindungsgemäßen Verfahren beschrieben sind, gelten dabei selbstverständlich auch im Zusammenhang mit der erfindungsgemäßen Vorrichtung und umgekehrt. Dabei können die in den Ansprüchen und in der Beschreibung erwähnten Merkmale jeweils einzeln oder in Kombination erfindungswesentlich sein.

Die Erfindung offenbart eine elektrische Steckeraufnahme für ein Fahrzeug mit mindestens einem Kontaktelement, wobei die Steckeraufnahme ein Gehäuse mit einer Öffnung aufweist und durch die Öffnung ein Stecker mit mindestens einer Kontaktelementaufnahme durchführbar ist. Erfindungsgemäß ist hierbei vorgesehen, dass das Gehäuse eine Führungskontur für den Stecker aufweist, wodurch der Stecker mit der Kontaktelementaufnahme in Richtung des Kontaktelementes zur Herstellung eines elektrischen Kontaktes führbar ist. Damit kann ein direkter Befestigungskontakt des Kontaktelementes mit dem Gehäuse der Steckeraufnahme unterbleiben. Das Kontaktelement ragt lediglich durch die Öffnung, wobei keine Kräfte über das Kontaktelement direkt an das Gehäuse im Falle eines Kontaktschlusses des Steckers mit der Steckeraufnahme übertragen werden. Die Führungskontur des Gehäuses ermöglicht es, dass der Stecker im Einsteckvorgang in die elektrische Steckeraufnahme derart geführt wird, dass ein Verkanten des Steckers in der Steckeraufnahme nicht erfolgen kann. Dabei ist die Führungskontur als Wandung ausgeführt, die mehrere zurückspringende Bereiche aufweist. Dadurch kann der Stecker durch mehrere verjüngende Bereiche geführt werden, bevor das Kontaktelement mit der Kontaktelementaufnahme in Berührung kommt. Dadurch wird schon während des Einführens des Steckers in die Steckeraufnahme die Führung des Steckers bestimmt. Es können weitere Führungskonturen in Betracht kommen, die sich außerhalb der Öffnung der Steckeraufnahme befinden und die komplementär mit der Geometrie des Steckers ausgebildet sind. Damit wird eine noch genauere Führung des Steckers in die Steckeraufnahme ermöglicht. Ein Verkanten des Steckers in die Steckeraufnahme wird damit sicher verhindert, wobei eine ungewollte Beschädigung der Kontaktelemente und/oder ein Umknicken der Kontaktelemente in der Steckeraufnahme verhindert werden kann. Der Einsatz eines Steckerkorbes zur Führung des Steckers kann dabei unterbleiben.

Besonders vorteilhaft ist es, dass die Steckeraufnahme einen Schaltungsträger aufweist, wobei auf dem Schaltungsträger die Kontaktelemente über einen Einpresskontakt elektrisch mit dem Schaltungsträger verbunden sind. Damit kann der Montageaufwand der Steckeraufnahme reduziert werden. Der Einsatz von Lötmitteln wird damit vermieden. Eine Erhitzung des Schaltungsträgers, welche eine elektronische Platine sein kann, wird damit nicht gefordert, wobei bei einem Lötverfahren die Platine erhitzt werden müsste. Dies kann zu einer Schädigung von empfindlichen Schaltkreisen, die auf dem Schaltungsträger verbaut sein können, führen. Zudem können die Montagekosten der Steckeraufnahme dadurch reduziert werden. Weiterhin können zusätzliche Bauteile zur Steckerführung und Kontaktabschirmung entfallen, was sich positiv auf die Bauteil- und Montagekosten auswirkt.

Weiterhin ist es vorteilhaft, dass die Führungskontur derart ausgestaltet ist, dass die Kontaktelementaufnahme des Steckers nur durch die Führungskontur passgenau auf das Kontaktelement zuführbar ist. Bei kommerziellen Steckeraufnahmen übernehmen die Kontaktelemente die Führung des Steckers in die Steckeraufnahme. Damit können Kontaktelemente beschädigt werden. Dies kann sich insbesondere durch ein Verbiegen oder Verknicken des Kontaktelementes bei der Einführung des Steckers in die Steckeraufnahme äußern. Die Führungskontur hilft dabei, dass die Kontaktelementaufnahmen bei dem letztendlichen Zusammenschluss mit den Kontaktelementen exakt gegenüber positioniert werden, so dass bei einem weiteren Eindringen des Steckers in die Steckeraufnahme eine Beschädigung des Kontaktelementes durch Verbiegen oder Verknicken definitiv ausgeschlossen ist. Dabei kann die Führungskontur auch oberhalb der Kontaktelemente angeordnet sein, sodass der Stecker zunächst eine gewisse Strecke durch die Öffnung geführt werden muss, bevor das Kontaktelement der Kontaktelementaufnahme zugeführt wird. Damit kann der Stecker durch einen Kanal entlanggeführt werden, sodass eine sichere Führung angenommen werden kann. Weiterhin kann die Führungskontur in die Öffnung der Steckeraufnahme angeordnet sein, wobei die Führungskontur verschiedene geometrische Formen annehmen kann. Die Führungskontur kann dabei mit zusätzlichen Merkmalen ausgestattet sein, wie z. B. mit Führungsschlitzen, die ein Verdrehen des Steckers bei Einbringung in die Steckeraufnahme verhindern können.

Es ist vorteilhaft, dass bei einem Zusammenschluss des Steckers mit der Steckeraufnahme eine Abschirmung eines Steckerbereiches erfolgt. Der Stecker und die Steckeraufnahme können dabei metallisch ausgeführt sein. Eine metallische Ausführung des Steckers und der Steckeraufnahme bietet den Vorteil, dass bei einem Zusammenschluss des Steckers mit der Steckeraufnahme eine elektromagnetische Abschirmung des dadurch umspannten Raumes durch den Stecker und der Steckeraufnahme erfolgt. Eine metallische Ausführung des Steckers und der Steckeraufnahme kann erst sinnvoll in Betracht gezogen werden, wenn der Einsatz eines Steckerkorbes zur Führung des Steckers nicht in Betracht gezogen werden muss. Bei der Ausführung des Steckerkorbes in einem elektrisch leitenden Material ist die Gefahr eines elektrischen Kurzschlusses zwischen Steckerkorb und Kontaktelement sehr groß, da die Kontaktelemente durch Löcher in dem Steckerkorb geführt werden müssen. Beim erfindungsgemäßen Gedanken entfällt der Steckerkorb, so dass ohne Gefahr eines möglichen Kurzschlusses zwischen Steckerkorb und Kontaktelement ein elektrisch leitendes Material, wie z.B. Metall, gewählt werden kann. Sollten der Stecker und die Steckeraufnahme aus einem Kunststoff gefertigt sein, so wird der innere Bereich, der sich aufspannt durch einen Zusammenschluss des Steckers mit der Steckeraufnahme, zumindest von Verunreinigungen geschützt. Das Eindringen von Staub, Schmutz und dergleichen kann dadurch wirkungsvoll verhindert werden.

Erfindungsgemäß ist vorgesehen, dass an der Steckeraufnahme ein Sicherungselement angeordnet ist, welches den Stecker an der Steckeraufnahme kraft- und/oder formschlüssig anordnet. Als Sicherungselement kann hierbei ein Gewinde zum Tragen kommen, dass sich um die Öffnung des Gehäuses befindet. Nach erfolgtem Zusammenschluss des Steckers mit der Steckeraufnahme kann dabei eine Überwurfmutter, welche um den Stecker angeordnet sein kann, einen kraft- und/oder formschlüssigen Zusammenschluss bewirken. Allerdings sind auch weitere Sicherungselemente denkbar, wie z. B. Sicherungshaken oder Spannbänder.

Weiterhin ist es vorteilhaft, dass um die Öffnung ein Dichtring angeordnet ist, wobei bei einem Zusammenschluss des Steckers mit der Steckeraufnahme der elektrische Kontakt zwischen Kontaktelement und Kontaktelementaufnahme vor Feuchtigkeit, Flüssigkeiten und/oder Verunreinigungen geschützt ist. Die Exposition des Steckers und der Steckeraufnahme in feuchten Räumen kann dadurch gewährleistet werden. Damit können verschiedene Schutzarten, welche in IP-Codes eingeteilt sind, erreicht werden. Der Dichtring kann an dem Gehäuse durch ein Spritzgussverfahren angebracht sein oder auch nachträglich zwischen dem Stecker und der Steckeraufnahme angeordnet werden. Die Aussetzung des Steckers mit der Steckeraufnahme in einem Fahrzeug kann dabei auch im Motorraum des Fahrzeuges erfolgen, der erfahrungsgemäß einer hohen Feuchtigkeit ausgesetzt sein kann.

Weiterhin ist es vorteilhaft, dass das Gehäuse mindestens eine Aufnahme aufweist, welche die Befestigung der Steckeraufnahme an dem Kraftfahrzeug ermöglicht. Die Aufnahme kann dabei als Öffnung ausgestaltet sein, durch die über eine Schraube mit der Fahrzeugkarosserie eine kraft- und/oder formflüssige Verbindung hergestellt werden kann. Auch können die Aufnahmen derart ausgestaltet sein, dass Haken, die an der Fahrzeugkarosserie befestigt sind, durch die Aufnahme hindurchgeführt werden können, um somit ebenfalls einen sicheren Halt der Steckeraufnahme an dem Kraftfahrzeug zu ermöglichen. Auch können Klebe- oder Schweißverfahren zum Einsatz kommen, wobei die Aufnahme als Schweißfahne ausgebildet ist, die thermisch von dem Gehäuse der Steckeraufnahme getrennt ist. Dadurch können während des Schweißvorganges thermische Übergänge von der Aufnahme auf das Steckergehäuse verhindert werden, was insbesondere zum Schutz der möglichen Elektronik, die sich auf dem Schaltungsträger befinden kann, vorgenommen werden kann.

Es ist vorteilhaft, dass das Gehäuse der Steckeraufnahme durch ein Metalldruckgussverfahren herstellbar ist. Dadurch können metallische Werkstoffe mit niedrigem Schmelzpunkt zum Einsatz kommen. Zudem ist ein Metalldruckgussverfahren vorteilhaft für eine Serien- oder Massenproduktion. Durch die Nutzung eines Metalldruckgussverfahrens kann damit das Gehäuse galvanisch mit der Fahrzeugkarosserie verbunden werden, was wiederum wichtig ist, um das Gehäuse auf Fahrzeugmasse zu bekommen. Durch den Druckguss besitzt das Gehäuse eine hohe Biegefestigkeit. Dies ist wichtig im Verbau eines Kraftfahrzeuges. Zudem können die in einem Metalldruckgussverfahren hergestellten Erzeugnisse auch höheren Temperaturen ausgesetzt werden, sodass ein Verbau des Gehäuses in der Nähe des Verbrennungsmotors des Kraftfahrzeuges vorstellbar ist. Ein weiterer Vorteil besteht darin, dass ein Metallgehäuse eine elektromagnetische Schirmwirkung erzeugt.

Weiterhin ist es vorteilhaft, dass das Gehäuse der Steckeraufnahme zweiteilig ausgestaltet ist. Es ist dabei vorstellbar, dass das Gehäuse aus einer Ober- und einer Unterschale besteht, wobei komplementäre Ausgestaltungen der Ober- und Unterschale zu einem Zusammenschluss führen können. In die Unterschale des Gehäuses kann dann der Schaltungsträger eingesetzt werden, der durch Druck der Oberschale in dem Gehäuse eingeklemmt werden kann. Dadurch entfällt ein Verschrauben oder Verrasten des Schaltungsträgers mit dem Gehäuse. Die Ober- an die Unterschale kann dann durch eine Schraub-, Schweiß- oder Klebverbindung angebracht werden. Dies erleichtert den Montageaufwand und kann die Herstellungskosten der Steckeraufnahme reduzieren. Zudem können an der Unterschale Kühlrippen angebracht sein. Die Kühlrippen können dabei die mögliche entstehende Wärme des Schaltungsträgers an die Außenluft wirkungsvoll abgegeben.

Weitere Maßnahmen und Vorteile der Erfindung ergeben sich aus den Ansprüchen, der nachfolgenden Beschreibung und den Zeichnungen. In den Zeichnungen ist die Erfindung dargestellt. Dabei können die in den Ansprüchen und in der Beschreibung erwähnten Merkmale jeweils einzeln für sich oder in beliebiger Kombination erfindungswesentlich sein. Es zeigen:
- Fig. 1: Eine schematische Ansicht eines Schnitts durch eine elektrische Steckeraufnahme,
- Fig. 2: eine schematische Draufsicht einer elektrischen Steckeraufnahme und
- Fig. 3: eine schematische Ansicht eines Steckers.

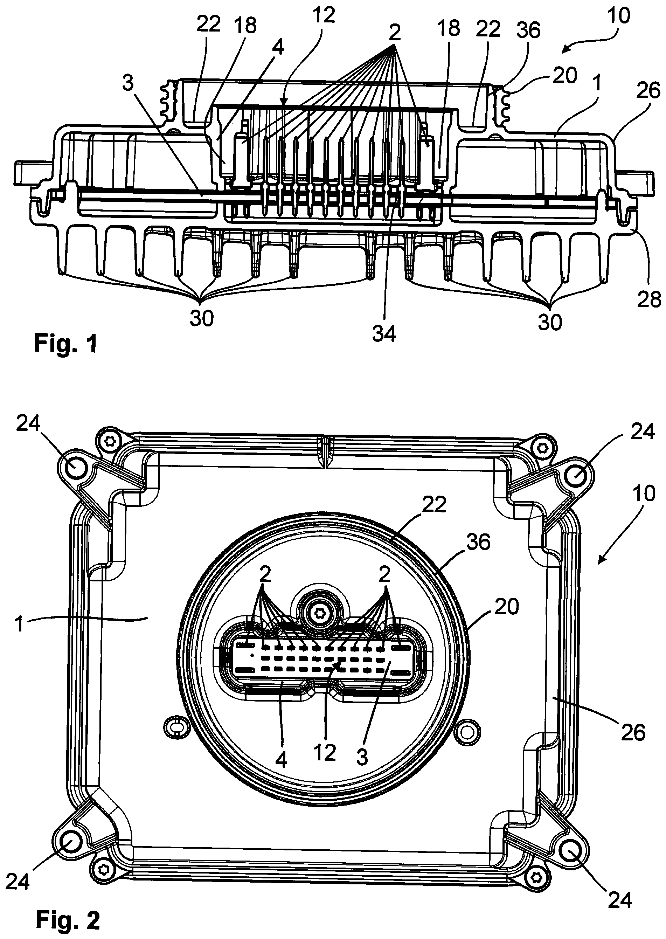

In Figur 1 ist eine schematische Ansicht eines Schnitts einer elektrischen Steckeraufnahme 10 dargestellt. Das Gehäuse 1 ist dabei zweistückig ausgestaltet. Eine Unterschale 28 nimmt dabei einen Schaltungsträger 3 auf. Der Schaltungsträger 3 liegt in der Unterschale 28. Die endgültige Befestigung des Schaltungsträgers 3 erfolgt durch eine Montage einer Oberschale 26 an die Unterschale 28, wobei an der Oberschale 26 Anschlagflächen 32 ausgeformt sind, die den Schaltungsträger 3 an die Unterschale 28 drücken. Damit wird der Schaltungsträger 3 sicher in dem dadurch entstehenden Gehäuse 1 von Zusammenschluss der Unterschale 28 mit der Oberschale 26 gehalten. Die Oberschale 26 kann dann mit der Unterschale 28 verschraubt oder auch verklebt werden. Auf dem Schaltungsträger 3 befinden sich Kontaktelemente 2, die durch eine Öffnung 12 des Gehäuses 1 hineinragen. Die Öffnung 12 wird durch eine Wandung erzeugt, die eine Führungskontur 4 aufweist. Die Führungskontur 4 weist dabei mehrere Vorsprünge auf, die sich in Richtung des Gehäuseinneren, d. h. in Richtung des Schaltungsträgers 3, verjüngt. Diese Führungskontur ermöglicht es, dass ein Stecker, der in die Öffnung 12 eingesetzt wird, sich nicht verkanten kann. Dadurch werden die Kontaktelemente 2 nur vertikal belastet, d. h. in Richtung des Schaltungsträgers 3. Eine horizontale Belastung, welche ein Verknicken oder Verbiegen der Kontaktelemente zur Folge hätte, wird dadurch sicher ausgeschlossen. Die Kontaktelemente 2 besitzen an ihrem unteren Ende zu dem Schaltungsträger 3 hin eine Verdickung 34, sodass bei einem Druck auf das Kontaktelement 2 in Richtung Schaltungsträger 3 dieses nicht weiter als bis zur Verdickung 34 auf dem Schaltungsträger 3 positioniert wird. Um die Öffnung 12 befindet sich eine zweite Wandung 36, die ebenfalls komplementär zu einem Stecker 16 ausgestaltet ist, so dass eine weitere Führung des Steckers 16 in die Steckeraufnahme 10 erfolgen kann. Um die zweite Wandung 36 ist ein Gewinde als Sicherungselement 20 angeordnet, wobei der Stecker 16 über eine Überwurfmutter 21 an das Gehäuse kraft- und/oder formschlüssig angeordnet werden kann. An der Unterschale 28 sind Kühlrippen 30 angeordnet, welche die entstehende Wärme im Gehäuseinneren 1 wirkungsvoll nach außen transportieren kann. Dies gilt insbesondere, wenn das Gehäuse, d. h. die Ober- und Unterschale in einem Metalldruckgussverfahren hergestellt worden sind. Wenn der Stecker 16 in die Öffnung 12 geführt wird und der Stecker 16 ebenfalls metallisch ausgeführt ist, so bilden sich Kammerbereiche 18, die eine elektromagnetische Abschirmung erfahren, wenn beide Elemente, der Stecker 16 und die Steckeraufnahme 10 metallisch ausgeführt sind.

In Figur 2 ist eine schematische Draufsicht einer Steckeraufnahme 10 dargestellt. An der Steckeraufnahme 10 sind mehrere Aufnahmen 24 zu erkennen, diese Aufnahmen 24 bieten eine Öffnung, durch die eine Schraube hindurchgeführt werden kann, zwecks Verbindung der Steckeraufnahme 10 mit einer Fahrzeugkarosserie. Auch können die Öffnungen der Aufnahmen 24 zur Aufnahme von Haken, welche im Fahrzeuginneren angeordnet sind, dienen. Es ist die Öffnung 12 zu sehen, wobei ein direkter Blick auf den Schaltungsträger 3 ermöglicht wird. Auf dem Schaltungsträger 3 sind die Kontaktelemente 2 angeordnet. Die Öffnung 2 wird über eine Wandung mit einer Führungskontur 4 gebildet. Man kann erkennen, dass die Öffnung nicht kreisförmig ausgestaltet ist, sondern eine bestimmte Geometrie aufweist, wobei ein komplementärer Stecker 16 in diese Geometrie einsetzbar ist. Ein Verdrehen des Steckers 16, sodass der Stecker 16 falsch in die Steckeraufnahme 10 eingesetzt werden könnte, wird dadurch ausgeschlossen. Die zweite Wandung 36 weist dabei ein Sicherungselement 20 auf, welches hier ebenfalls in der Draufsicht als Gewinde ausgestaltet ist. Der Dichtring 22 ermöglicht es, bei einem Zusammenschluss des Steckers 16 mit der Steckeraufnahme 10, dass das Gehäuseinnere vor Verunreinigungen geschützt werden kann.

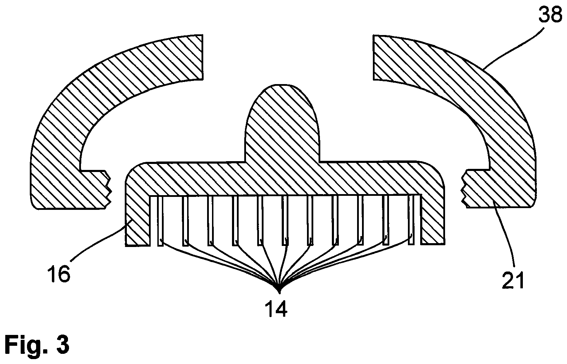

In Figur 3 ist schematisch ein Stecker 16 dargestellt. Der Stecker 16 weist dabei Kontaktelementaufnahmen 14 auf, die mit den Kontaktelementen 2 eine elektrische Verbindung eingehen können. An dem Stecker 16 ist ein Gegensicherungselement 21 angeordnet. Dieses Gegensicherungselement 21 ist eine Überwurfmutter, welche mit dem Sicherungselement 20 der Steckeraufnahme 10, welche als Gewinde ausgestaltet ist, eine form- und/oder kraftschlüssige Verbindung eingehen kann. Durch Schulterbereiche 38 kann dabei der Stecker 16 an das Gehäuse 1 angepresst werden. Damit wird der Stecker 16 sicher an die Steckeraufnahme 10 verbunden.

### Bezugszeichenliste

- 1: Gehäuse
- 2: Kontaktelement
- 3: Schaltungselement
- 4: Führungskontur
- 10: Steckeraufnahme
- 12: Öffnung
- 14: Kontaktaufnahmelement
- 16: Stecker
- 18: Kammerbereiche
- 20: Sicherungselement
- 21: Gegensicherungselement
- 22: Dichtelement
- 24: Aufnahme
- 26: Oberschale
- 28: Unterschale
- 30: Kühlrippe
- 32: Anschlagfläche
- 34: Verdickung
- 36: Wandung
- 38: Schulterbereich

## Patentansprüche

1. Elektrische Steckeraufnahme (10) für ein Fahrzeug mit mindestens einem Kontaktelement (2), wobei die Steckeraufnahme (10) ein Gehäuse (1) mit einer Öffnung (12) aufweist und durch die Öffnung (12) ein Stecker (16) mit mindestens einer Kontaktelementaufnahme (14) durchführbar ist, wobei das Gehäuse (1) eine Führungskontur (4) für den Stecker (16) aufweist, wodurch der Stecker (16) mit der Kontaktelementaufnahme (14) in Richtung des Kontaktelements (2) zur Herstellung eines elektrischen Kontaktes führbar ist, wobei die Führungskontur (4) als Wandung ausgeführt ist, die die Öffnung (12) bildet und mehrere zurückspringende Bereiche aufweist, **dadurch gekennzeichnet, dass** um die Öffnung (12) eine zweite Wandung (36) angeordnet ist, die eine weitere Führungskontur für den Stecker (16) bildet, wobei um die zweite Wandung (36) ein Gewinde als Sicherungselement (20) angeordnet ist, welches den Stecker (16) an der Steckeraufnahme (10) kraft- und/oder formschlüssig anordnet.

2. Elektrische Steckeraufnahme (10) nach Anspruch 1, **dadurch gekennzeichnet, dass** die Steckeraufnahme (10) einen Schaltungsträger (3) aufweist, wobei auf dem Schaltungsträger (3) die Kontaktelemente (2) über einen Einpresskontakt elektrisch mit dem Schaltungsträger (3) verbunden sind.

3. Elektrische Steckeraufnahme (10) nach Anspruch 1 oder 2, **dadurch gekennzeichnet, dass** die Führungskontur (4) derart ausgestaltet ist, dass die Kontaktelementaufnahme (14) des Steckers (16) nur durch die Führungskontur (4) passgenau auf das Kontaktelement (2) zuführbar ist.

4. Elektrische Steckeraufnahme (10) nach einem der Ansprüche 1 bis 3, **dadurch gekennzeichnet, dass** bei einem Zusammenschluss des Steckers (16) mit der Steckeraufnahme (10) eine Abschirmung mindestens eines Kammerbereiches (18) erfolgt.

5. Elektrische Steckeraufnahme (10) nach einem der vorhergehenden Ansprüche, **dadurch gekennzeichnet, dass** um die Öffnung ein Dichtelement (22) angeordnet ist, wobei bei einem Zusammenschluss des Steckers (16) mit der Steckeraufnahme (10) der elektrische Kontakt zwischen Kontaktelement (2) und Kontaktelementaufnahme (14) vor Feuchtigkeit, Flüssigkeiten und/oder Verunreinigungen geschützt ist.

6. Elektrische Steckeraufnahme (10) nach einem der vorhergehenden Ansprüche, **dadurch gekennzeichnet, dass** das Gehäuse (1) mindestens eine Aufnahme (24) aufweist, welche die Befestigung der Steckeraufnahme (10) an dem Kraftfahrzeug ermöglicht.

7. Elektrische Steckeraufnahme (10) nach einem der vorhergehenden Ansprüche, **dadurch gekennzeichnet, dass** das Gehäuse (1) der Steckeraufnahme (10) durch ein Metall-Druckgussverfahren herstellbar ist.

8. Elektrische Steckeraufnahme (10) nach einem der vorhergehenden Ansprüche, **dadurch gekennzeichnet, dass** das Gehäuse (1) der Steckeraufnahme (10) zweiteilig ausgestaltet ist.

## Claims

1. Electrical connector holder (10) for a vehicle with at least one contact element (2), where the connector holder (10) has a housing (1) with an opening (12) and a connector (16) with at least one contact element holder (14) can be passed through the opening (12), where the housing (1) has a guide contour (4) for the connector (16) enabling the connector (16) with the contact element holder (14) to be guided in the direction of the contact element (2) to create an electric contact, where the guide contour (4) is executed as a wall that forms the opening (12) has several recoiling areas, **characterized in that** a second wall (36) is arranged around the opening (12) that forms a second guide contour for the connector (16), whereby a thread is arranged around the second wall (36) acting as a safety element (20), which provides for a force and/or form-locking arrangement of the connector (16) at the connector holder (10).

2. Electrical connector holder (10) in accordance with Claim 1, **characterized in that** the connector holder (10) has an interconnect device (3), where on the interconnect device (3) the contact elements (2) are electrically connected to the interconnect device (3) by means of a press-fit contact.

3. Electrical connector holder (10) in accordance with Claim 1 or 2 **characterized in that** the guide contour (4) is designed in such a way that the contact element holder (14) of the connector (16) can only be guided exactly onto the contact element (2) only through the guide contour (4).

4. Electrical connector holder (10) in accordance with one of the Claims 1 through 3 **characterized in that** when the connector (16) is connected to the connector holder (10) at least one chamber area (18) is shielded off

5. Electrical connector holder (10) in accordance with one of the preceding claims **characterized in that** a sealing element (22) is arranged around the opening, where, when the connector (16) is connected with the connector holder (10), the electrical contact between the contact element (2) and the contact element holder (14) is protected from dampness, fluids and/or dirt.

6. Electrical connector holder (10) in accordance with one of the preceding claims, **characterized in that** the housing (1) has at least one holder (24) that facilitates the fastening of the connector holder (10) to the motor vehicle.

7. Electrical connector holder (10) in accordance with one of the preceding claims, **characterized in that** the housing (1) of the connector holder (10) can be produced using a metal die casting process.

8. Electrical connector holder (10) in accordance with one of the preceding claims, **characterized in that** the housing (1) of the connector holder (10) is designed as two parts.

## Revendications

1. Logement de fiche électrique (10) pour un véhicule présentant au moins un élément de contact (2), sachant que le logement de fiche (10) présente un carter (1) avec une ouverture (12) dans laquelle une fiche (16) présentant au moins un logement d'élément de contact (14) peut être insérée, sachant que le carter (1) présente une bordure de liaison (4) pour la fiche (16), par laquelle la fiche (16) peut être insérée avec le logement pour élément de contact (14) en direction de l'élément de contact (2) pour créer un contact électrique, sachant que la bordure de liaison (4) est conçue comme une paroi qui forme l'ouverture (12) et présente plusieurs parties saillantes dirigées vers l'arrière, **caractérisé en ce que,** une deuxième paroi (36) est placée autour de l'ouverture (12) et forme une nouvelle bordure de liaison pour la fiche (16), sachant qu'un filetage faisant office d'élément de sécurité (20) est placé autour de la deuxième paroi (36) et fixe la fiche (16) sur le logement de fiche (10) par force et/ou forme.

2. Logement de fiche électrique (10) selon la revendication 1, **caractérisé en ce que,** le logement de fiche (10) présente un support de connexion (3), sachant que les éléments de contact (2) sont reliés électriquement au support de connexion (3) via un contact à pression.

3. Logement de fiche électrique (10) selon la revendication 1 ou 2, **caractérisé en ce que,** la bordure de liaison (4) est conçue de façon à ce que le logement d'élément de contact (14) de la fiche (16) ne puisse être inséré que via la bordure de liaison, exactement sur l'élément de contact (2).

4. Logement de fiche électrique (10) selon l'une des revendications 1 à 3, **caractérisé en ce que,** lors d'une connexion de la fiche (16) au logement de fiche (10), une protection se forme pour au moins un compartiment tampon (18).

5. Logement de fiche électrique (10) selon l'une des revendications précédente, **caractérisé en ce que,** un élément d'étanchéité (22) est placé autour de l'ouverture, sachant que, lors d'une connexion de la fiche (16) au logement de fiche (10), le contact électrique entre l'élément de contact (2) et le logement d'élément de contact (14) est protégé contre l'humidité, les liquides et/ou les impuretés.

6. Logement de fiche électrique (10) selon l'une des revendications précédentes, **caractérisé en ce que,** le carter (1) présente au moins un logement (24) permettant de fixer le logement de fiche (10) au véhicule.

7. Logement de fiche électrique (10) selon l'une des revendications précédentes, **caractérisé en ce que,** le carter (1) du logement de fiche (10) peut être fabriqué selon un procédé de coulage de métal sous pression.

8. Logement de fiche électrique (10) selon l'une des revendications précédentes, **caractérisé en ce que,** le carter (1) du logement de fiche (10) se compose de deux pièces.
